# EUROPEAN PATENT APPLICATION

(11) **EP 1 868 107 A1**
(43) Date of publication of application: **19.12.2007**
(21) Application number: 06722155.6
(22) Date of filing: 24.03.2006
(51) Int. Cl.: G06F 13/14, H04B 10/06, H03K 17/78

(54) **MULTIMEDIA TERMINAL AND METHOD OF CONVERTING THE OPERATING STATE OF MULTIMEDIA TERMINAL**

(30) Priority: 29.03.2005 CN 200510059604
(71) Applicant: Huawei Technologies Co., Ltd., Longgang District, Shenzhen Guangdong 518129 (CN)
(72) Inventor: WANG, Xiaorong, Huawei Administration Building, Shenzhen, Guangdong 518129 (CN)
(74) Representative: Körber, Martin Hans
(86) International application number: PCT/CN2006/000503
(87) International publication number: WO 2006/102832

(57) **Abstract**

A method for switching a state of a media terminal includes: detecting for an infrared signal emitted by a human body around the multimedia terminal; processing the infrared signal into a trigger signal, inputting the trigger signal into the multimedia terminal, and switching the multimedia terminal from a power-saving state to an operating state according to the trigger signal. Embodiments of the present invention also provide two multimedia terminals. An infrared signal detection unit and an infrared signal processing unit are added to the existing multimedia terminal to make the multimedia terminal have an infrared signal detection function. Once the multimedia terminal detects that a person moves around it, the multimedia terminal automatically switches to the operating state. Embodiments of the present invention can prolong the lifetime of the multimedia terminal, reduce power consumption of the multimedia terminal and upgrade the multimedia terminal.

## Description

### Field of the Invention

The present invention relates to terminal technologies, and particularly to a multimedia terminal and a method for switching a state of the multimedia terminal.

### Background of the Invention

In recent years, multimedia terminals have been applied widely. Besides being applied in personal entertainments and business meetings, some multimedia terminals emerge in public places, e.g., for playing advertisements in buses, elevators and office buildings. In addition, some multimedia terminals with self-service functions come into use in some banks and government departments, these multimedia terminals can provide multimedia information to various users.

At present, most multimedia terminals in public places do not take special care for a case that nobody is around the multimedia terminal. Usually, the multimedia terminal keeps in operation round-the-clock. For example, a multimedia terminal used for playing advertisements will keep playing continuously whether there is an audience around or not; and an Automatic Teller Machine (ATM) or other multimedia terminals with the self-service functions will also keep in operation whether there is a user. However, there may be nobody for a rather long time. For example, it is quite possible that nobody is there for the whole night. Keeping in operation shortens lifetime of the multimedia terminal, especially a display device such as Cathode Ray Tube (CRT) and Thin-Film Transistor (TFT). Display circuit of the display device has high voltage circuits and light emitting devices such as filaments, tubes. Long time operation dramatically shortens the lifetime of the display device. Since the display device and a processor take a large part of power consumption of the multimedia terminal, the long time operation also wastes power, harms environment and wastes money.

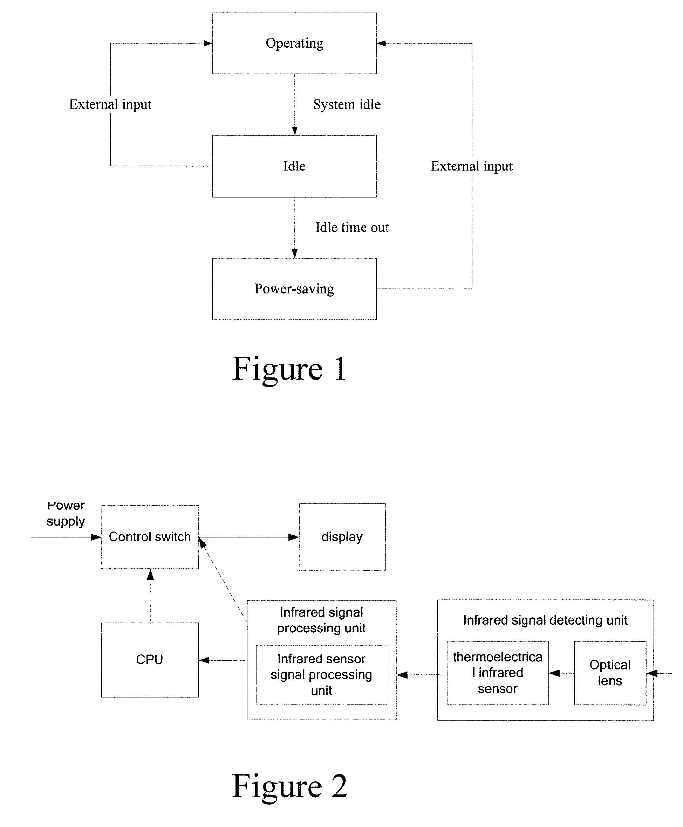

In the prior art, there are some multimedia terminals capable of switching to a power-saving state automatically; Figure 1 is a schematic diagram illustrating a state switching of a multimedia terminal capable of automatically switching to the power-saving state. If having kept in an idle state for a time period, i.e., there is nobody operating the multimedia terminal, the multimedia terminal will automatically turn off some unnecessary circuits such as the display and a hard disk. At this time, the multimedia terminal enters into the power-saving state. Once there is somebody operating the multimedia terminal, e.g., touching a key of the multimedia terminal, the multimedia terminal returns to the operating state immediately. Programs running in this kind of multimedia terminal include a main program, a system timing program and an idle-time calculating program. The main program is used for dealing with interruptions and for calling various application programs. The system timing program is used for providing a system timing function similar to a second hand in a clock, usually generates a message or an interruption. The idle-time calculating program is used for calculating system idle time. During a normal operation, the main program is in a receiving state to receive an external input signal and calls different application programs according to the external input signal. When a specific time set for the system arrives, the main program determines whether the system is in the idle state. If not, the main program clears an idle-time counter. The idle-time counter restarts to count the system idle time. If the system is in the idle state, the main program does nothing to the idle-time counter and waits for the idle-time counter to reach a pre-configured value. When the idle-time counter reaches the pre-configured value, the idle-time calculating program generates an event. The main program responses to the event and switches the multimedia terminal to the power-saving state. Once there is an external input, the multimedia terminal returns to the operating state from the power-saving state. After entering into the power-saving state, the main program may process according to characteristics of chips and peripheral equipment of the multimedia terminal. For the chip supporting the power-saving state, pins of the chip may be configured into the power-saving state by software. For the chip not supporting the power-saving state, power supply of the chip may be switched off. For a Central Processing Unit (CPU) or a Digital Signal Processor (DSP), power consumption may be reduced by lowering an operating frequency and an operating voltage level of the CPU or the DSP. Usually, input equipment is not turned off in the power-saving state for responding to the external input in time.

The multimedia terminal capable of automatically switching to the power-saving state can turn off automatically, but cannot turn on automatically. If not knowing the multimedia terminal, the public may think that the multimedia terminal goes wrong, which influence the normal use of the multimedia terminal.

### Summary of the Invention

Embodiments of the present invention provide a multimedia terminal and a method for switching a state of the multimedia terminal, so that the multimedia terminal may return to an operating state without a human operation.

According to one aspect of the present invention, a method for switching a state of a multimedia terminal includes: detecting for an infrared signal emitted by a human body around a multimedia terminal; and processing the infrared signal into a trigger signal, inputting the trigger signal into the multimedia terminal, and switching the multimedia terminal from a power-saving state to an operating state according to the trigger signal.

According to another aspect of the present invention, an infrared signal detection unit, configured to detect an infrared signal emitted by a human body around the multimedia terminal, convert the infrared signal into an electrical signal, and input the electrical signal to an infrared signal processing unit;
the infrared signal processing unit, configured to receive the electrical signal from the infrared signal detection unit, process the electrical signal into a trigger signal and input the trigger signal to a Central Processing Unit (CPU);
the CPU, configured to keep the multimedia terminal in an operating state or switch the multimedia terminal from a power-saving state to the operating state after receiving the trigger signal.

According to another aspect of the present invention, a multimedia terminal includes: a display and a power supply circuit for the display;
an infrared signal detection unit, configured to detect an infrared signal emitted by a human body around the multimedia terminal, convert the infrared signal into an electrical signal and input the electrical signal to an infrared signal processing unit;
the infrared signal processing unit, configured to receive the electrical signal from the infrared signal detection unit, process the electrical signal into a trigger signal and output the trigger signal to a controllable switch; and
the controllable switch, configured in the power supply circuit, connected between the display and a power supply and configured to put through the display with the power supply according to the trigger signal.

According to embodiments of the present invention, an infrared signal detection unit and an infrared signal processing unit are added to the existing multimedia terminal to make the multimedia terminal have an infrared signal detection function and thus capable of converting the infrared signal emitted by a human body around the multimedia terminal into a trigger signal and inputting the trigger signal to the multimedia terminal; once the multimedia terminal detects that a person moves around it, the multimedia terminal automatically switches to the operating state. Embodiments of the present invention prolong the lifetime of the multimedia terminal, reduce power consumption of the multimedia terminal and upgrade the multimedia terminal.

### Brief description of the drawings

Figure 1 is a schematic diagram illustrating a state switching of a multimedia terminal capable of automatically going into power-saving state.
Figure 2 is a schematic diagram illustrating a structure of the multimedia terminal according to an embodiment of the present invention.
Figure 3 is a flowchart for state switching of the multimedia terminal according to an embodiment of the present invention.
Figure 4 is a schematic diagram illustrating a circuit for controlling a display switch using a relay according to an embodiment of the present invention.
Figure 5 illustrates a detailed circuit according to an embodiment of the present invention.

### Detailed description of the Invention

The present invention is hereinafter described in details with reference to accompanying drawings and embodiments to make the technical solution, objective and merits of the present invention more apparent.

As shown in Figure 2, in an embodiment of the present invention, an infrared signal detection unit and an infrared signal processing unit are added to the existing multimedia terminal. The infrared signal detection unit is used for detecting an infrared signal in the surroundings and converting the infrared signal into an electrical signal. The infrared signal processing unit is used for processing the electrical signal sent from the infrared signal detection unit into a trigger signal and sends the trigger signal to a CPU or a controllable switch in the multimedia terminal. The CPU or the controllable switch switches the multimedia terminal from the power-saving state to the operating state or keeps the multimedia terminal in the operating state.

The infrared signal detecting unit is set on the surface of the multimedia terminal, includes a thermoelectrical infrared sensor and an optical lens; wherein the optical lens is used for enlarging a detection scope of the thermoelectrical infrared sensor. The thermoelectrical infrared sensor is configured to face to objects to be detected. The optical lens is configured in front of the thermoelectrical infrared sensor and usually adopts a Fresnel lens. Thus, the infrared signal emitted by the surroundings may be infracted to the thermoelectrical infrared sensor by the Fresnel lens. The thermoelectrical infrared sensor determines whether there is a person around the multimedia terminal by sensing a difference between the infrared signal emitted by the human body and that emitted by the surroundings. The thermoelectrical infrared sensor includes two thermoelectrical units in series or parallel connection. Electric polarization directions of two thermoelectrical units are opposite to each other. The infrared signal emitted by the surroundings produces almost the same effect on two thermoelectrical units, thus thermoelectrical effects generated by two thermoelectrical units counteract each other and no electrical signal is outputted. Once a person enters into the detection area, the infrared signal emitted by the human body is focused by the Fresnel lens and received by the thermoelectrical units. In this case, quantities of heats received by two thermoelectrical units are different. Therefore the thermoelectrical quantities are different and cannot counteract each other, thereby there is an electrical signal outputted. If the detection scope is not required to be very large, the infrared signal detection unit may also not include the optical lens.

The infrared signal processing unit may be installed on a single board inside the multimedia terminal, usually implemented by an infrared sensor signal processor. The infrared sensor signal processor includes an amplifying circuit, a comparing circuit and a filter circuit connected in series. After receiving the electric signal from the thermoelectrical infrared sensor, the infrared sensor signal processor processes the electric signal including amplifying, comparing and filtering in successive. After processing the electrical signal, the infrared sensor signal processor outputs a trigger signal to an interrupt pin or an I/O pin of the CPU. The CPU receives the trigger signal through an interrupt manner or a query manner. After receiving the trigger signal, the CPU switches the multimedia terminal from the power-saving state to the operating state if the multimedia terminal is in the power-saving state, or keeps the multimedia terminal in the operating state if the multimedia terminal is in the operating state.

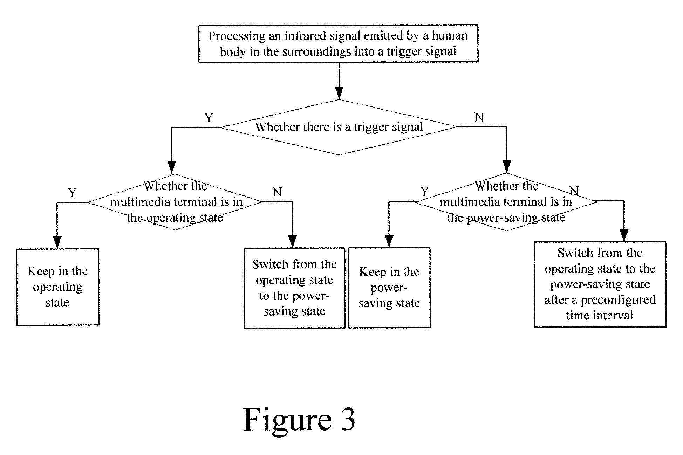

As shown in Figure 3, when a system time arrives, the main program of the multimedia terminal checks whether the interruption pin or the I/O pin of the CPU receives the trigger signal. If the interruption pin or the I/O pin of the CPU receives the trigger signal, the main progress determines whether the multimedia terminal is in the operating state. If the multimedia terminal is in the operating state, the multimedia terminal keeps in the operating state; if the multimedia terminal is in the power-saving state, the main program switches the multimedia terminal from the power-saving state to the operating state. If the interruption pin or the I/O pin of the CPU does not receive the trigger signal, the main program determines whether the multimedia terminal is in the power-saving state. If the multimedia terminal is in the power-saving state, the main program keeps the multimedia terminal in the power-saving state. If the multimedia terminal is in the operating state, a timing program starts. If the interruption pin or the I/O pin of the CPU does not receive the trigger signal after a preconfigured time interval, the main program switches the multimedia terminal from the operating state to the power-saving state. The preconfigured time interval may be set according to an application scenario of the multimedia terminal. If the time interval is configured too short, the multimedia terminal may frequently switch between the power-saving state and the operating state, which shortens the lifetime of the multimedia terminal. Generally, it is appropriate to configure the time interval to be 5-10 minutes.

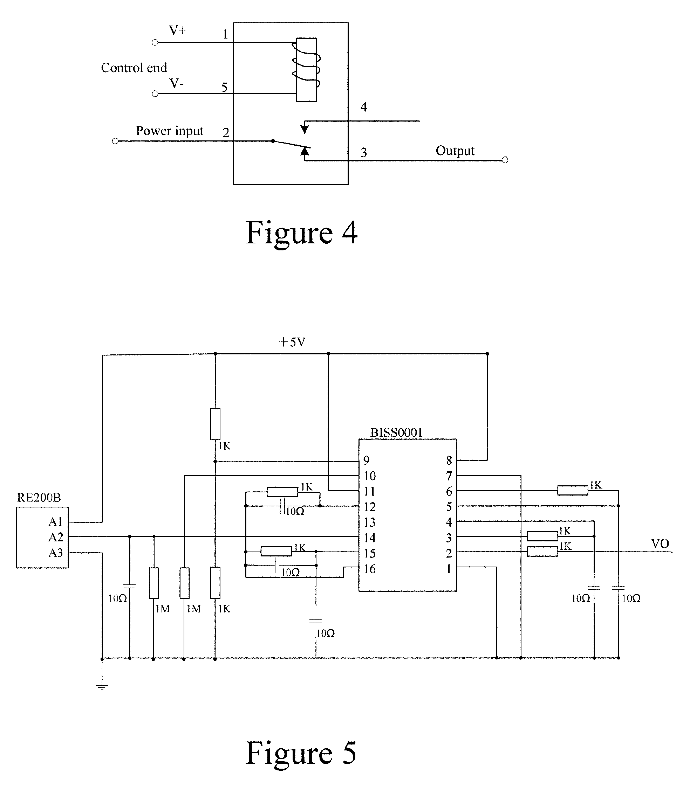

Different types of multimedia terminals enter into the power-saving state in different ways. For the multimedia terminal whose CPU and display support the power-saving state, if the multimedia terminal is in the operating state and does not receive the trigger signal after the preconfigured time interval, both the CPU and the display of the multimedia terminal enter into the power-saving state. For the multimedia terminal whose CPU supports the power-saving state but the display does not support the power-saving state, a controllable switch may by added to a power supply circuit of the display. The controllable switch may be a relay or a controllable silicon switch. Hereinafter the relay is taken as an example. An appropriate control voltage may be applied to a control end of the relay to open or close the relay, thereby control the power supply of the display. Preferably, the relay is normally closed, i.e., without an action in a control circuit, the relay is put through in default. Thus, even if a process circuit is down, the display can be supplied with power normally. Figure 4 is a schematic diagram illustrating a circuit for controlling a display using a relay. Pin 2 of the relay is connected with the power supply, and pin 3 of the relay is connected with the input of the power supply circuit. When there is no current flowing between pins 1 and 5, pin 2 is connected with pin 3, and the power supply circuit supplies power for the display normally. When there is a current flowing between pins 1 and 5, pin 2 is connected with pin 4, the power supply circuit of the display is disconnected. For the multimedia terminal whose CPU does not support the power-saving state, it is only required to turn off the display by the relay.

As shown in Figure 5, the type of the thermoelectrical infrared sensor adopted in the embodiments of the present invention may be RE200B, and the infrared sensor signal processor may be BISS0001. Pin A2 of the RE200B is connected with pin 14 of the BISS0001. When a person enters into the detection area, pin A2 of the RE200B generates an electrical signal. The electrical signal is inputted into pin 14 of the BISS0001. After being processed including amplifying, comparing and filtering noise interference, the electrical signal is converted into a trigger signal VO and outputted at pin 2 of the BISS0001. The trigger signal VO is inputted to the interruption pin or I/O pin of the CPU. For example, if the CPU is a single-chip microcomputer 8051, the trigger signal VO may be inputted to interruption pin 1 of P3.3. When the system time arrives, the main program of the multimedia terminal checks whether the interruption pin or the I/O pin of the CPU receives the trigger signal. If the interruption pin or the I/O pin of the CPU receives the trigger signal, the main program keeps the multimedia terminal in the operating state or switches the multimedia terminal from the power-saving state to the operating state. If the interruption pin or the I/O pin of the CPU does not receive the trigger signal, the main program keeps the multimedia terminal in the power-saving state or switches the multimedia terminal from the operating state to the power-saving state after the preconfigured time interval.

An example is hereinafter given to further describe effects brought by the embodiments of the present invention. The solution provided by the embodiments of the present invention may be used in a videophone. Besides functions of the traditional videophone, the videophone in this example may have a function of playing advertisements after subscribing for an advertisement service by cooperating with a network provider. In the advertisement service, the advertisements are sent to the videophone by a server. By applying the solution provided by the embodiments of the present invention, when a person passes by the videophone, screen of the videophone will automatically turn on to display the advertisements. After being displayed, the advertisements may be saved locally for future query or erased by an owner. Even though the videophone will stop playing after a time period without human operation, the videophone is able to play the advertisements automatically once a person passes by, which enhanced effects for playing advertisements and avoids waste of resources brought by continuous playing.

The solution of the present invention can be modified appropriately during the detailed implementation, to meet the detailed requirements of the specific cases. It is thereby understood that the specific embodiments according to the present invention are just demonstrative, and are not for use in limiting the protection scope of the present invention.

## Claims

1. A method for switching a state of a multimedia terminal, comprising:
detecting for an infrared signal emitted by a human body around a multimedia terminal; and
processing the infrared signal into a trigger signal, inputting the trigger signal into the multimedia terminal, and switching the multimedia terminal from a power-saving state to an operating state according to the trigger signal.

2. The method of claim 1, wherein the processing the infrared signal into the trigger signal comprises:
converting the infrared signal into an electrical signal; and
processing the electrical signal into the trigger signal by amplifying, comparing and filtering.

3. The method of claim 1 or 2, wherein the multimedia terminal comprises a Central Processing Unit (CPU), the inputting the trigger signal into the multimedia terminal and switching the multimedia terminal from the power-saving state to the operating state according to the trigger signal comprises:
inputting the trigger signal into the CPU; and
switching, by the CPU, the multimedia terminal from the power-saving state to the operating state according to the trigger signal or keeping the multimedia terminal in the operating state according to the trigger signal.

4. The method of claim 3, wherein if the CPU does not receive the trigger signal for a preconfigured time interval, keeping, by the CPU, the multimedia terminal in the power-saving state or switching the multimedia terminal from the operating state to the power-saving state.

5. The method of claim 3, wherein the CPU receives the trigger signal via an interrupt manner or a query manner.

6. The method of claim 1 or 2, wherein a power supply circuit of a display of the multimedia terminal comprises a controllable switch;
the inputting the infrared signal to the multimedia terminal comprises: inputting the trigger signal to the controllable switch; and
the switching the multimedia terminal from the power-saving state to the operating state according to the trigger signal comprises: keeping, by the controllable switch, the power supply circuit in a switch-on state or switching the power supply circuit from a switch-off state to the switch-on state after receiving the trigger signal.

7. A multimedia terminal, comprising:
an infrared signal detection unit, configured to detect an infrared signal emitted by a human body around the multimedia terminal, convert the infrared signal into an electrical signal, and input the electrical signal to an infrared signal processing unit;
the infrared signal processing unit, configured to receive the electrical signal from the infrared signal detection unit, process the electrical signal into a trigger signal and input the trigger signal to a Central Processing Unit (CPU);
the CPU, configured to keep the multimedia terminal in an operating state or switch the multimedia terminal from a power-saving state to the operating state after receiving the trigger signal.

8. The multimedia terminal of claim 7, wherein the infrared signal processing unit inputs the trigger signal to an interruption pin or an I/O pin of the CPU.

9. The multimedia terminal of claim 7, wherein the infrared signal detection unit comprises a thermoelectrical infrared sensor; wherein the thermoelectrical infrared sensor comprises two thermoelectrical units connected in series or in parallel, and electric polarization directions of two thermoelectrical units are opposite to each other.

10. The multimedia terminal of claim 9, wherein the infrared signal detection unit further comprises an optical lens, configured to enlarging a detection scope of the thermoelectrical infrared sensor.

11. The multimedia terminal of claim 10, wherein the optical lens is a Fresnel lens.

12. The multimedia terminal of claim 7, wherein the infrared signal processing unit comprises: an amplifying circuit, a comparing circuit and a filter circuit connected in series for successively amplifying, comparing and filtering.

13. The multimedia terminal of claim 7, further comprising: a display and a power supply of a power supply circuit for the display; a controllable switch, connected between the display and the power supply of the power supply circuit for the display;
the CPU is configured to send the trigger signal to the controllable switch; and
the controllable switch is configured to put through the display and the power supply according to the trigger signal.

14. The multimedia terminal of claim 13, wherein the controllable switch is a relay or a controllable silicon switch.

15. A multimedia terminal, comprising a display and a power supply circuit for the display;
an infrared signal detection unit, configured to detect an infrared signal emitted by a human body around the multimedia terminal, convert the infrared signal into an electrical signal and input the electrical signal to an infrared signal processing unit;
the infrared signal processing unit, configured to receive the electrical signal from the infrared signal detection unit, process the electrical signal into a trigger signal and output the trigger signal to a controllable switch; and
the controllable switch, configured in the power supply circuit, connected between the display and a power supply and configured to put through the display with the power supply according to the trigger signal.

16. The multimedia terminal of claim 15, wherein the controllable switch is a relay or a controllable silicon switch.
